# EUROPEAN PATENT SPECIFICATION

(11) **EP 0 926 507 B1**
(45) Date of publication and mention of the grant of the patent: **06.06.2007**
(21) Application number: 98123652.4
(22) Date of filing: 10.12.1998
(51) Int. Cl.: G01R 19/165

(54) **Method for displaying battery filling state in TDMA radio terminal and corresponding radio terminal**
Anzeigeverfahren für einen Batterie-Füllungszustand in einem Funk-endgerät mit TDMA-Mode und dazugehöriges Funkendgerät
Méthode d'affichage de l'état de remplissage d'une pile dans un terminal radio à mode TDMA et terminal radio correspondant

(30) Priority: 16.12.1997 KR 9769200
(43) Date of publication of application: 30.06.1999
(73) Proprietor: SAMSUNG ELECTRONICS CO., LTD., Suwon-City, Kyungki-do (KR)
(72) Inventor: Cho, Sung-Min, Kumi-shi, Kyongsangbuk-do (KR)
(74) Representative: Grünecker, Kinkeldey, Stockmair & Schwanhäusser Anwaltssozietät

(56) References cited:
- EP-A- 0 608 086
- FR-A- 2 335 063

## Description

The present invention relates to a TDMA (Time Division Multiple Access) radio terminal, and in particular, to a method and a TDMA radio terminal for stably displaying a battery filling state where the battery voltage temporarily varies during transmission and reception periods.

A radio terminal such as a cordless telephone generally has a battery state displaying function for measuring a current battery voltage and displaying on a liquid crystal display (LCD) the battery state into a full battery state, a half battery state, a low battery state and an empty battery state, so that a user may recognize the battery state.

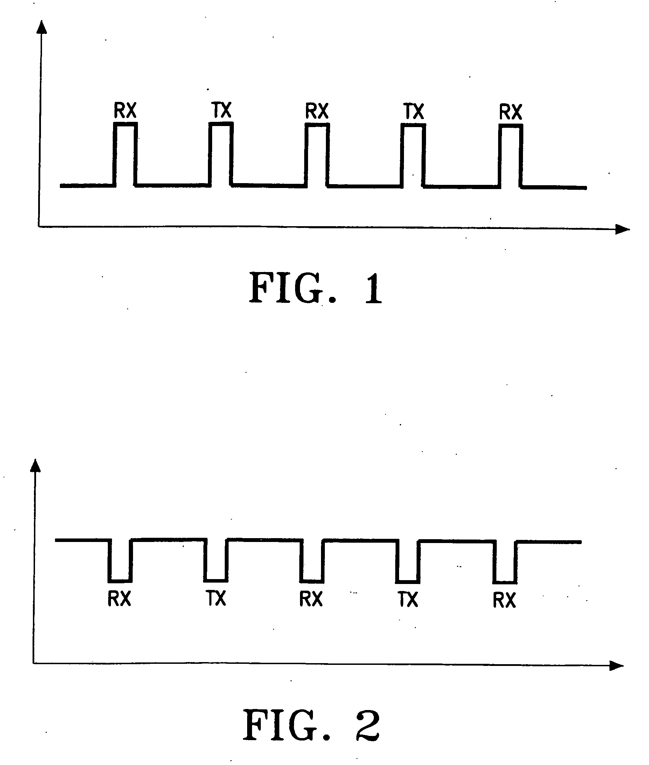

However, in a TDMA radio terminal such as a DECT (Digital European Cordless Telephone), current consumption abruptly increases during transmission (Tx) and reception (Rx), as illustrated in FIG. 1. As a result, the battery voltage is also abruptly changed during transmission and reception, as illustrated in FIG. 2. Accordingly, it is difficult to stably display the battery voltage due to the continual variation of the battery voltage.

EP 0 608 086 A2 relates to a battery charge indicator for transceiver. A radio telecommunication apparatus sends signals to a base station for a first period of radio channels established by a time division multiple access system. The apparatus has a battery whose voltage decreases in response to consumption of the battery. The apparatus measures the voltage of the battery only during a second period other than the first period and estimates remaining energy of the battery in response to the measured voltage. The apparatus comprises recognizing means for recognizing whether the apparatus is sending signals to the base station, measuring means responsive to the recognizing means for measuring the voltage of the battery, only when the apparatus is not sending the signals to the base station, and estimating means responsive to the measuring means for estimating the remaining energy of the battery.

FR 2 335 063 A relates to an electronic charge indicator for a battery. The electronic charge indicator for a battery comprises light means having a first state indicative of a normal state of charge of the battery and the second stage indicative of an abnormal battery charge state. The electronic charge indicator for a battery further comprises a circuit means responsive to the voltage across the battery to set the signal light means into its second state when the battery voltage is lower than a predetermined low threshold or in excess of a predetermined high threshold and into its first state when the battery voltage is intermediate the thresholds. For increasing battery voltage, a low threshold has, for example, a value V1. The fact that this value is reached causes for example an extinction of a signal lamp forming the light means and, at the same time, the reduction of the threshold to a value V2. If the battery voltage falls, the signal lamp will only light again when the value of this voltage becomes lower than V2, itself lower than V1.

Reference will be made to a conventional method for displaying a battery voltage in a TDMA radio terminal with reference to FIGs. 1 to 4.

FIG. 1 illustrates variation of the current consumption during transmission and reception periods in the TDMA radio terminal, and FIG. 2 illustrates variation of the battery voltage during the transmission and reception periods in the TDMA radio terminal. Referring to FIGs. 1 and 2, the current consumption abruptly increases during the transmission and reception periods, which results in the abrupt variation of the battery voltage.

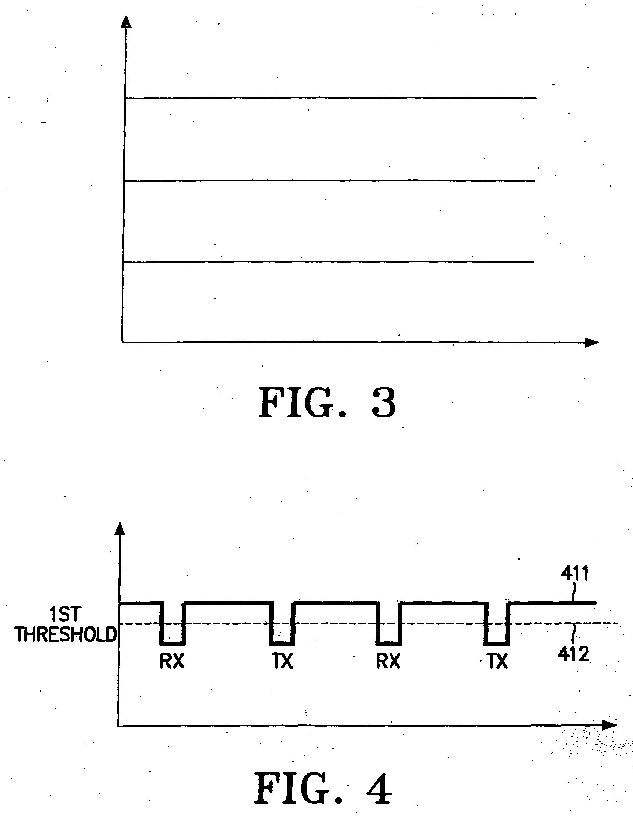

FIG. 3 illustrates battery state areas in the conventional TDMA radio terminal. Referring to FIG. 3, the battery state is divided into four areas: a full battery state area, a half battery state area, a low battery state area and an empty battery state area. For example, when the battery voltage exceeds a first threshold level (for the low battery state), the TDMA radio terminal displays the low battery state on the display, and when the battery voltage is lower than the first threshold level, the TDMA radio terminal displays the empty battery state. However, such a conventional method cannot stably display the battery state due to the continual variation of the battery voltage during the transmission and reception periods.

For example, assume that a battery voltage 411 is changed during transmission and reception, swinging on the first threshold level 412, as illustrated in FIG. 4. In such a case, the TDMA radio terminal displays the low battery state in an idle state and the empty battery state during transmission and reception due to the temporal change of the battery voltage. In result, as transmission and reception are repeated at intervals, the terminal repeatedly changes the battery states, which decreases reliability of the battery state display function

It is the object of the present invention to provide a method and a corresponding TDMA radio terminal for stably displaying a battery filling state where the battery voltage temporarily varies during transmission and reception periods in a TDMA radio terminal.

This object is solved by the subject matter of the independent claims.

Preferred embodiments are defined in the dependent claims.

A TDMA radio terminal detects a battery voltage and displays a corresponding battery state, when the battery voltage belongs to any one of plural battery state areas. However, when the battery voltage belong to any one of buffer zones each intervening between the adjacent battery state areas, the radio terminal displays a previous battery state and then stores the battery state being currently displayed as a previous battery state.

The above features and advantages ofthe present invention will become more apparent from the following detailed description when taken in conjunction with the accompanying drawings in which:
FIG. 1 is a diagram illustrating variation of current consumption in a common TDMA radio terminal;
FIG. 2 is a diagram illustrating variation of a battery voltage in a common TDMA raio terminal;
FIG. 3 is a diagram illustrating threshold levels for the respective battery states in a conventional TDMA radio terminal;
FIG. 4 is a diagram for explaining a state where a battery voltage is changed during transmission and reception, swinging on a threshold level;
FIG. 5 is a block diagram of a TDMA radio terminal to which the present invention is applied;
FIG. 6 is a diagram illustrating threshold levels for the respective battery states according to an embodiment of the present invention;
FIG. 7 is a diagram for explaining a state where a battery voltage is changed during transmission and reception, swinging on a threshold level;
FIGs. 8A to 8D are diagrams illustrating icons indicating a full battery state, a half battery state, a low battery state and an empty battery state, respectively; and
FIG. 9 is a flowchart illustrating a method for displaying a battery voltage according to an embodiment of the present invention.

A preferred embodiment of the present invention will be described hereinbelow with reference to the accompanying drawings. In the following description, well known functions or constructions are not described in detail since they would obscure the invention in unnecessary detail.

In the specification, a term "buffer zone" refers to a zone intervening between two adjacent battery state areas.

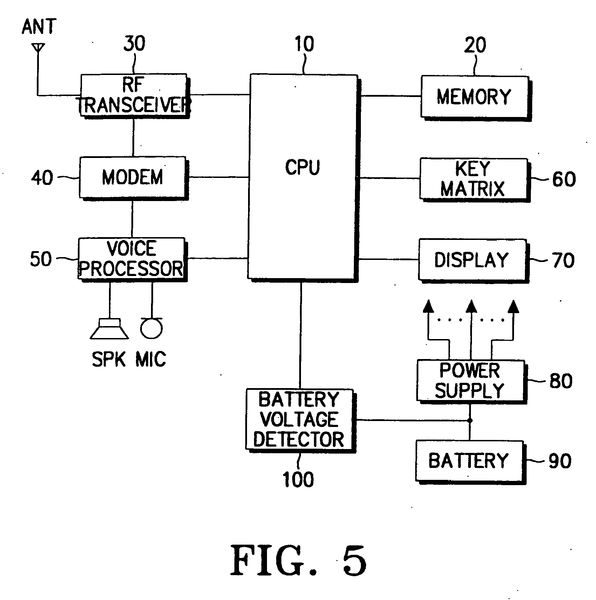

FIG. 5 illustrates a block diagram of a TDMA radio terminal to which the present invention is applied. In FIG. 5, a controller 10, a CPU (Central Processing Unit), controls the overall operations of the TDMA radio terminal, and in particular, measures a battery voltage depending upon a battery voltage detection signal output from a battery voltage detector 100, and displays a corresponding battery state on a display 70. A memory 20 includes a ROM (Read Only Memory) for storing a program for controlling the radio terminal and a RAM (Random Access Memory) for temporarily storing data generated during execution of the program. A voice processor 50 connected to a microphone (or mouthpiece) MIC and a speaker (or earpiece) SPK, converts an analog voice signal input from the microphone MIC to ADPCM (Adaptive Differential Pulse Code Modulation) data, and processes a signal input from a modem 40 to a voice signal to output it to the speaker SPK. The modem 40 converts the ADPCM data input from the voice processor 50 to a baseband signal to output it an RF (Radio Frequency) transceiver 30, and converts a signal input from the RF transceiver 30 to digital data to output it to the voice processor 50. The RF transceiver 30 converts the analog baseband signal input from the modem 40 to an RF signal to send it to a fixed part (or base unit) through a radio channel, and down-converts an RF signal received through an antenna ANT to an analog baseband signal to output it to the modem 40. A key input unit 60, a key matrix including a plurality of numeric keys, provides the controller 10 with key data generated by the user's key manipulation. A display 70, an LCD, displays operating states of the radio terminal (or portable unit) under the control of the controller 10. Further, the display 70 displays a battery state in response to battery state display data output from the controller 10 according to the present invention. A power supply 80 is provided with a power supply voltage from a battery 90 and decreases the power supply voltage to specified levels for the respective parts. The battery 90, which is normally put on the fixed part FP (not shown), is charged with a charge voltage supplied from the fixed part FP and provides the battery voltage to the power supply 80. The battery voltage detector 100 detects the voltage level of the battery 90 and provides a corresponding battery voltage detection signal to the controller 10. The battery voltage detector 100 includes an analog-to-digital (A/D) convertor for converting an analog voltage level signal from the battery 90 to digital data.

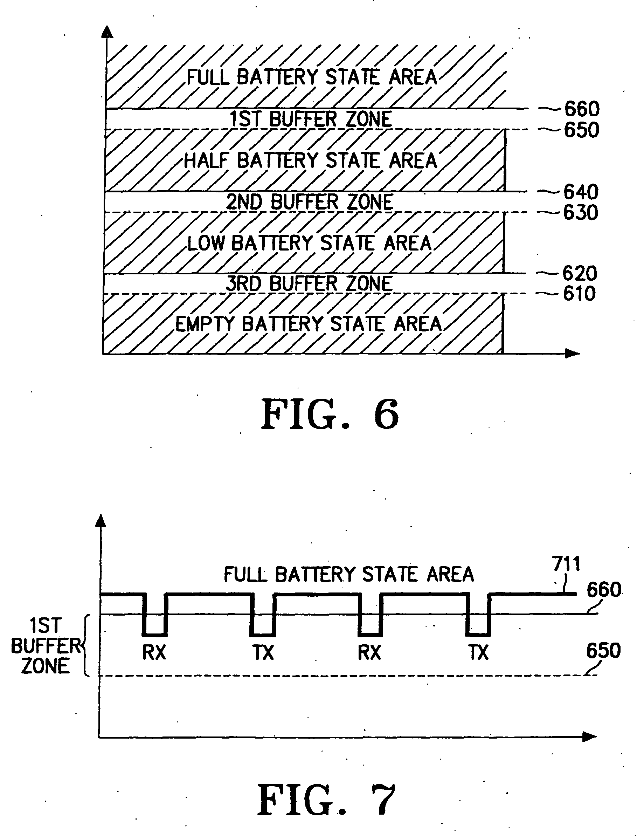

FIG. 6 illustrates threshold levels for the respective battery states according to an embodiment ofthe present invention. As illustrated, the battery state according to the present invention is divided into a full battery state area, a half battery state area, a low battery state area and an empty battery state area, wherein buffer zones intervene between adjacent battery state areas. Specifically, a first buffer zone intervenes between the full battery state area and the half battery state area, a second buffer zone intervenes between the half battery state area and the low battery state area, and a third buffer zone intervenes between the low battery state area and the empty battery state area. Further, the first to third buffer zones each have upper limits (660, 640 and 620) and lower limits (650, 630 and 610). That is, the entire battery state area is divided into four battery state areas and three buffer zones.

The controller 10 determines whether the battery voltage detected by the battery voltage detector 100 belongs to any one of the four battery state areas. If so, the controller 10 displays the corresponding battery state. However, when the detected battery voltage belongs to any one of the three buffer zones, the controller 10 judges on which limit of a specific buffer zone the detected battery voltage swings. If the battery voltage swings on the upper limit of the specific buffer zone, the controller 10 displays the battery state corresponding to the battery state area situated over the above stated upper limit. However, when the battery voltage swings on the lower limit of the specific buffer zone, the controller 10 displays the battery state corresponding to the battery state area situated below the above stated upper limit. The width of the buffer zones should be wider than a variation width of the battery voltage during transmission and reception.

Referring to FIG. 7, assume that a battery voltage 711 is varied during transmission and reception, swinging on the upper limit 660 ofthe first buffer zone. That is, the battery voltage belongs to the first buffer zone during transmission and reception, while it belongs to the full battery state area during the idle state. In such a case, the controller 10 displays the full battery state, unless the battery voltage drops to the lower limit 650 of the first buffer zone during transmission and reception.

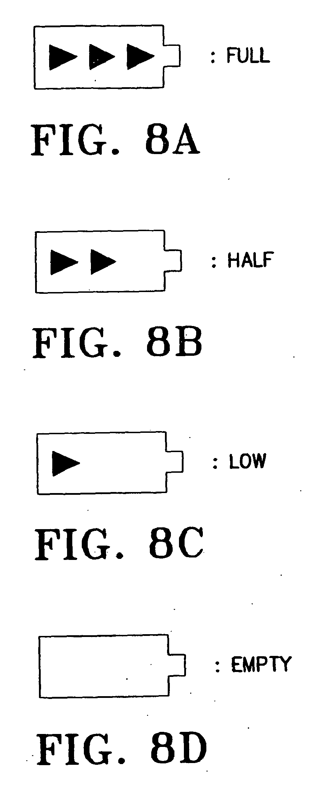

FIGs. 8A to 8D illustrate icons displayed on the display 70, indicating the full battery state, the half battery state, the low battery state and the empty battery state, respectively.

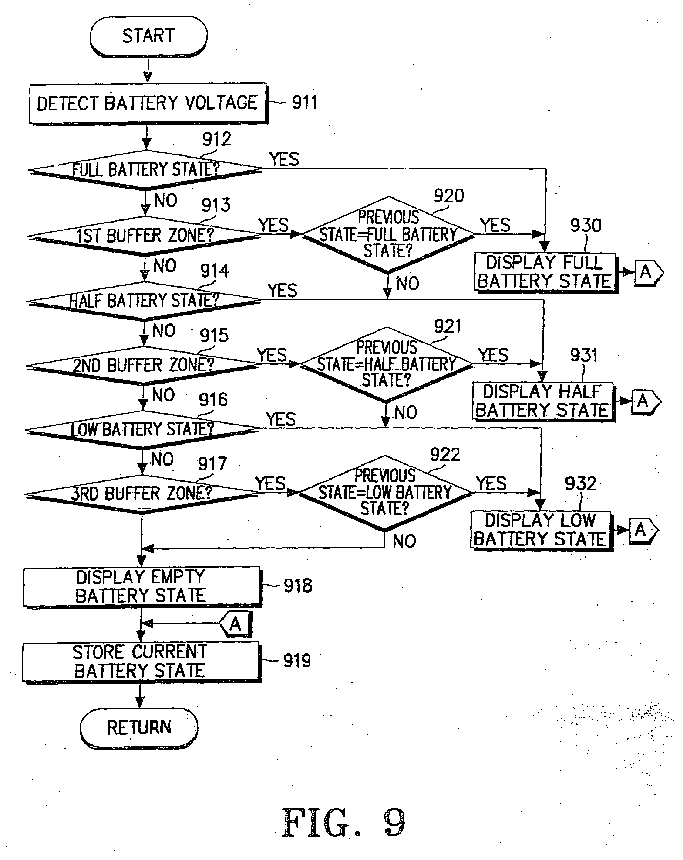

Now, reference will be made to a method for displaying the battery filling state according to an embodiment of the present invention, with reference to FIG. 9. The controller 10 receives the battery voltage detection signal output from the battery voltage detector 100 in step 911. The controller 10 judges in step 912 whether the battery voltage belongs to the full battery state area. If so, the controller 10 displays the full battery state in step 930 and then proceeds to step 919. If not so, the controller 10 judges in step 913 whether the battery voltage belongs to the first buffer zone. If so, the controller 10 judges in step 920 whether a previous battery state is the full battery state. When the previous battery state is the full battery state, the controller 10 displays the full battery state in step 930 and then proceeds to step 919. When the previous battery state is not the full battery state, the controller 10 displays the half battery state on the display 70 in step 931 and then proceeds to step 919.

However, when the battery voltage does not belong to the first buffer zone in step 913, the controller 10 judges in step 914 whether the battery voltage belongs to the half battery state area. If so, the controller 10 displays the half battery state in step 931 and then proceeds to step 919. If not so, the controller 10 judges in step 915 whether the battery voltage belongs to the second buffer zone. If so, the controller 10 judges in step 921 whether the previous battery state is the half battery state. When the previous battery state is the half battery state, the controller 10 displays the half battery state in step 931 and then proceeds to step 919. However, when the previous battery state is not the half battery state, the controller 10 displays the low battery state on the display 70 in step 932 and then proceeds to step 919.

However, when the battery voltage does not belong to the second buffer zone in step 915, the controller 10 judges in step 916 whether the battery voltage belongs to the low battery state area. If so, the controller 10 displays the low battery state in step 932 and then proceeds to step 919. If not so, the controller 10 judges in step 917 whether the battery voltage belongs to the third buffer zone. If not so, the controller 10 displays the empty battery state in step 918. However, when the battery voltage belongs to the third buffer zone, the controller 10 judges in step 922 whether the previous battery state is the low battery state. When the previous battery state is the low battery state, the controller 10 displays the low battery state in step 932 and then proceeds to step 919. However, when the previous battery state is not the low battery state, the controller 10 displays the empty battery state on the display 70 in step 918 and then proceeds to step 919. In step 919, the controller 10 stores the battery state being currently displayed as a previous battery state and then returns to step 911.

As described above, the TDMA radio terminal of the invention can stably display the battery filling state, even though the battery voltage temporarily varies during transmission and reception periods.

While the invention has been shown and described with reference to a certain preferred embodiment thereof, it will be understood by those skilled in the art that various changes in form and details may be made therein without departing from the scope of the invention as defined by the appended claims.

## Claims

1. A TDMA radio terminal having a multi-level batteryfilling state display, the terminal, comprising:
means for detecting (912) a battery voltage; and
a controller (10) for judging in which one of plural battery state areas and plural buffer zones each intervening between adjacent battery state area the detected battery voltage is located, said buffer zones having a width wider than a variation width of the battery voltage during transmission and reception periods of said TDMA radio terminal,
wherein said controller (10) is arranged for displaying a corresponding battery state when the current battery voltage belongs to any one of said plural battery state areas, displaying a battery state relating to a previously detected battery voltage when the current battery voltage belongs to any one of said buffer zones, and storing (919) the battery state being currently displayed as a previous battery state.

2. A method for displaying a battery state in a TDMA radio terminal, comprising the steps of:
detecting (911) a battery voltage;
judging (912, 914, 916) whether the battery voltage belongs to any one of first to fourth battery state areas;
displaying (930) a first battery state corresponding to the first battery state area, when the battery voltage belongs to the first battery state areas;
judging (920) whether a previous battery state is the first battery state, when the battery voltage belongs to a first buffer zone intervening between the first and second battery state areas, displaying the first battery state when the previous battery state is the first battery state, and displaying the second battery state when the previous battery state is not the first battery state;
displaying (931) the second battery state corresponding to the second battery state area, when the battery state belongs to the second battery state area;
judging (921) whether the previous battery state is the second battery state, when the battery voltage belongs to a second buffer zone intervening between the second and third battery state areas, displaying the second battery state when the previous battery state is the second battery state, and displaying the third battery state when the previous battery state is not the second battery state;
displaying (932) the third battery state corresponding to the third battery state area, when the battery state belongs to the third battery state area;
judging (922) whether the previous battery state is the third battery state, when the battery voltage belongs to a third buffer zone intervening between the third and fourth battery state areas, displaying the third battery state when the previous battery state is the third battery state, and displaying the fourth battery state when the previous battery state is not the third battery state; and
storing (919) the battery state being currently displayed as a previous battery state,
said buffer zones having a width wider than a variation width of the battery voltage during transmission and reception periods of said TDMA radio terminal.

3. The method for displaying a battery state as claimed in claim 2, wherein the first to fourth battery states are a full battery state, a half battery state, a low battery state and an empty battery state, respectively.

## Patentansprüche

1. TDMA-Funk-Endgerät, das eine mehrstufige Batteriefüllzustands-Anzeige aufweist, wobei das Endgerät umfasst:
eine Einrichtung zum Erfassen (912) einer Batteriespannung; und
eine Steuereinheit (10), die entscheidet, in welcher von mehreren Batteriezustands-Bereichen und mehreren Pufferzonen, die jeweils zwischen benachbarten Batteriezustands-Bereichen angeordnet sind, sich die erfasste Batteriespannung befindet, wobei die Pufferzonen eine Breite haben, die größer ist als eine Schwankungsbreite der Batteriespannung während Sende- und Empfangsperioden des TDMA-Funk-Endgeräts, und die Steuereinheit (10) so eingerichtet ist, dass sie einen entsprechenden Batteriezustand anzeigt, wenn die aktuelle Batteriespannung zu einem der mehreren Batteriezustands-Bereichen gehört, einen Batteriezustand anzeigt, der sich auf eine zuvor erfasste Batteriespannung bezieht, wenn die aktuelle Batteriespannung zu einer der Pufferzonen gehört, und den Batteriezustand, der aktuell angezeigt wird, als einen vorangehenden Batteriezustand speichert (919).

2. Verfahren zum Anzeigen eines Batteriezustands in einem TDMA-Funk-Endgerät, das die folgenden Schritte umfasst:
Erfassen (911) einer Batteriespannung;
Entscheiden (912, 914, 916), ob die Batteriespannung zu einem ersten bis vierten Batteriezustands-Bereich gehört;
Anzeigen (930) eines ersten Batteriezustands, der dem ersten Batteriezustands-Bereich entspricht, wenn die Batteriespannung zu den ersten Batteriezustands-Bereichen gehört;
Entscheiden (920), ob ein vorangehender Batteriezustand der erste Batteriezustand ist, wenn die Batteriespannung zu einer ersten Pufferzone gehört, die zwischen dem ersten und dem zweiten Batteriezustands-Bereich angeordnet ist, Anzeigen des ersten Batteriezustands, wenn der vorangehende Batteriezustand der erste Batteriezustand ist, und Anzeigen des zweiten Batteriezustands, wenn der vorangehende Batteriezustand nicht der erste Batteriezustand ist;
Anzeigen (931) des zweiten Batteriezustands, der dem zweiten Batteriezustands-Bereich entspricht, wenn der Batteriezustand zu dem zweiten Batteriezustands-Bereich gehört;
Entscheiden (921), ob der vorangehende Batteriezustand der zweite Batteriezustand ist, wenn die Batteriespannung zu einer zweiten Pufferzone gehört, die sich zwischen dem zweiten und dem dritten Batteriezustands-Bereich befindet, Anzeigen des zweiten Batteriezustands, wenn der vorangehende Batteriezustand der zweite Batteriezustand ist, und Anzeigen des dritten Batteriezustands, wenn der vorangehende Batteriezustand nicht der zweite Batteriezustand ist;
Anzeigen (932) des dritten Batteriezustands, der dem zweiten Batteriezustands-Bereich entspricht, wenn der Batteriezustand zu dem dritten Batteriezustands-Bereich gehört;
Entscheiden (922), ob der vorangehende Batteriezustand der dritte Batteriezustand ist, wenn die Batteriespannung zu einer dritten Pufferzone gehört, die sich zwischen dem dritten und dem vierten Batteriezustands-Bereich befindet, Anzeigen des dritten Batteriezustands, wenn der vorangehende Batteriezustand der dritte Batteriezustand ist, und Anzeigen des vierten Batteriezustands, wenn der vorangehende Batteriezustand nicht der dritte Batteriezustand ist; und
Speichern (919) des aktuell angezeigten Batteriezustands als einen vorangehenden Batteriezustand,
wobei die Pufferzonen eine Breite haben, die größer ist als eine Schwankungsbreite der Batteriespannung während Sende- und Empfangsperioden des TDMA-Funk-Endgeräts.

3. Verfahren zum Anzeigen eines Batteriezustands nach Anspruch 2, wobei der erste bis vierte Batteriezustand ein Zustand voller Batterie, ein Zustand halbvoller Batterie, ein Zustand schwacher Batterie bzw. ein Zustand leerer Batterie sind.

## Revendications

1. Terminal radio AMRT ayant une visualisation d'état de remplissage de batterie à plusieurs niveaux, le terminal comprenant:
un moyen pour détecter (912) une tension de batterie ; et
une unité de commande (10) pour juger dans laquelle de multiples zones d'état de batterie et de multiples zones tampons, chacune d'elles étant intercalée entre des zones d'état de batterie adjacentes, se trouve la tension de batterie détectée, lesdites zones tampons ayant une largeur supérieure à une largeur de variation de la tension de batterie pendant des périodes d'émission et de réception dudit terminal radio AMRT,
dans lequel l'unité de commande (10) est agencée pour visualiser un état de batterie correspondant lorsque la tension de batterie présente appartient à l'une quelconque desdites multiples zones d'état de batterie, visualiser un état de batterie relatif à une tension de batterie détectée précédemment lorsque la tension de batterie présente appartient à l'une quelconque desdites zones tampons, et stocker (919) l'état de batterie qui est visualisé au moment présent comme un état de batterie antérieur.

2. Procédé pour visualiser un état de batterie dans un terminal radio AMRT, comprenant les étapes suivantes :
détecter (911) une tension de batterie ;
juger (912, 914, 916) si la tension de batterie appartient à une zone quelconque parmi des première à quatrième zones d'état de batterie ;
visualiser (930) un premier état de batterie correspondant à la première zone d'état de batterie, lorsque la tension de batterie appartient à la première zone d'état de batterie ;
juger (920) si un état de batterie antérieur est le premier état de batterie, lorsque la tension de batterie appartient à une première zone tampon intercalée entre les première et deuxième zones d'état de batterie, visualiser le premier état de batterie lorsque l'état de batterie antérieur est le premier état de batterie, et visualiser le deuxième état de batterie lorsque l'état de batterie antérieur n'est pas le premier état de batterie ;
visualiser (931) le deuxième état de batterie correspondant à la deuxième zone d'état de batterie, lorsque l'état de batterie appartient à la deuxième zone d'état de batterie ;
juger (921) si l'état de batterie antérieur est le deuxième état de batterie, lorsque la tension de batterie appartient à une deuxième zone tampon intercalée entre les deuxième et troisième zones d'état de batterie, visualiser le deuxième état de batterie lorsque l'état de batterie antérieur est le deuxième état de batterie, et visualiser le troisième état de batterie lorsque l'état de batterie antérieur n'est pas le deuxième état de batterie ;
visualiser (932) le troisième état de batterie correspondant à la troisième zone d'état de batterie lorsque l'état de batterie appartient à la troisième zone d'état de batterie ;
juger (922) si l'état de batterie antérieur est le troisième état de batterie, lorsque la tension de batterie appartient à une troisième zone tampon intercalée entre les troisième et quatrième zones d'état de batterie, visualiser le troisième état de batterie lorsque l'état de batterie antérieur est le troisième état de batterie, et visualiser le quatrième état de batterie lorsque l'état de batterie antérieur n'est pas le troisième état de batterie ; et
stocker (919) l'état de batterie visualisé au moment présent comme un état de batterie antérieur ;
lesdites zones tampons ayant une largeur supérieure à une largeur de variation de la tension de batterie pendant des périodes d'émission et de réception dudit terminal radio AMRT.

3. Procédé pour visualiser un état de batterie selon la revendication 2, dans lequel les premier à quatrième états de batterie sont respectivement un état de batterie plein, un état de batterie à moitié plein, un état de batterie bas et un état de batterie vide.
